# EUROPEAN PATENT APPLICATION

(11) **EP 4 783 230 A1**
(43) Date of publication of application: **29.07.2026**
(21) Application number: 24868175.1
(22) Date of filing: 10.09.2024
(51) Int. Cl.: H01L 21/304, F16L 1/00, H01L 21/306

(54) **SUBSTRATE PROCESSING DEVICE**

(30) Priority: 22.09.2023 JP 2023158165; 10.07.2024 JP 2024110864
(71) Applicant: SCREEN Holdings Co., Ltd., Kyoto-shi, Kyoto 602-8585 (JP)
(72) Inventor: OKA, Shogo, Kyoto-shi, Kyoto 602-8585 (JP); MORI, Ryohei, Kyoto-shi, Kyoto 602-8585 (JP); MORITA, Tomokazu, Kyoto-shi, Kyoto 602-8585 (JP); OSADA, Naoyuki, Kyoto-shi, Kyoto 602-8585 (JP)
(74) Representative: Kilian Kilian & Partner mbB
(86) International application number: PCT/JP2024/032433
(87) International publication number: WO 2025/063098

(57) **Abstract**

A substrate processing apparatus processes substrates. The substrate processing apparatus includes a plurality of pipings. Each of the plurality of pipings has an inner surface and an outer surface. A fluid flows on an inner side of the inner surface of each of the plurality of pipings. The plurality of pipings include at least one virgin material piping and one recycled material piping. The virgin material piping contains a virgin material of fluororesin. The recycled material piping contains a recycled material of fluororesin. At least one of either of marking and coloring to identify the virgin material piping and the recycled material piping is performed on at least one of either of the virgin material piping and the recycled material piping.

## Description

### Technical Field

The present invention relates to a substrate processing apparatus.

### Description of Related Art

The substrate processing apparatus includes a piping that makes a processing liquid flow and a piping that makes a gas flow. A fluororesin molded product is used for the piping that makes the processing liquid flow (see, for example, Patent Literature 1). The fluororesin molded product is used for a piping that is included in the piping that makes the gas flow and that is disposed under a chemical liquid atmosphere.

### Citation List

### Patent Literature

Patent Literature 1: Japanese Patent Application Publication No. 2020-155649

### Summary of Invention

### Technical Problem

However, saving environmental resources has been demanded more stringently than before. Since raw materials for fluororesins are natural materials and the amount of resources thereof is finite, saving of the raw materials for fluororesins (environmental resources) is also demanded.

The present invention has been made in view of the above problems, and an object of the present invention is to provide a substrate processing apparatus capable of saving environmental resources.

### Solution to Problem

According to one aspect of the present invention, a substrate processing apparatus processes a substrate. The substrate processing apparatus includes a plurality of pipings. Each of the plurality of pipings has an inner surface and an outer surface. A fluid flows on an inner side of the inner surface of each of the plurality of pipings. The plurality of pipings include at least one virgin material piping and one recycled material piping. The virgin material piping contains a virgin material of fluororesin. The recycled material piping contains a recycled material of fluororesin. At least one of either of marking and coloring to identify the virgin material piping and the recycled material piping is performed on at least one of either of the virgin material piping and the recycled material piping.

In a preferred embodiment, at least one of either of the virgin material piping and the recycled material piping has a marking portion between the inner surface and the outer surface. Marking to identify the virgin material piping and the recycled material piping is performed on the marking portion.

In a preferred embodiment, the substrate processing apparatus further includes a substrate processing portion. The substrate processing portion executes substrate processing on the substrate. The substrate processing portion has a chamber that houses the substrate. The at least one virgin material piping includes a piping disposed inside the chamber. The at least one recycled material piping includes a piping disposed outside the chamber.

In a preferred embodiment, the at least one virgin material piping includes a liquid supply piping that supplies a liquid to the substrate processing portion. A portion of the liquid supply piping is disposed inside the chamber, and the other portion of the liquid supply piping is disposed outside the chamber.

In a preferred embodiment, the substrate processing apparatus further includes a fluid cabinet. The fluid cabinet houses a liquid to be supplied to the substrate processing portion. The at least one virgin material piping includes a recovery piping. The recovery piping makes the liquid that is expelled from the substrate processing portion flow to the fluid cabinet. At least a portion of the recovery piping is disposed outside the chamber.

In a preferred embodiment, the at least one recycled material piping includes a drain piping. A liquid expelled from the substrate processing portion flows through the drain piping. The drain piping is disposed outside the chamber.

In a preferred embodiment, the plurality of pipings include a liquid supply piping that supplies a liquid to the substrate processing portion. The substrate processing apparatus further includes an opening-closing valve and a fluid box. The opening-closing valve is provided on the liquid supply piping. The opening-closing valve controls flow of the liquid via the liquid supply piping and its stoppage. The fluid box houses a portion of the liquid supply piping and the opening-closing valve. The at least one recycled material piping includes a gas piping that makes a gas flow. At least a portion of the gas piping is disposed inside the fluid box.

In a preferred embodiment, the marking portion further indicates a type of the fluid flowing through the virgin material piping or the recycled material piping.

In a preferred embodiment, the marking portion further indicates a location where the virgin material piping or the recycled material piping is disposed.

In a preferred embodiment, the marking portion further indicates a direction in which the fluid flowing through the virgin material piping or the recycled material piping flows.

In a preferred embodiment, the coloring is performed on the virgin material piping.

In a preferred embodiment, the coloring of black color is performed on at least one of either of the virgin material piping and the recycled material piping.

In a preferred embodiment, at least one of either of the virgin material piping and the recycled material piping includes a translucent portion on which the coloring is performed.

In a preferred embodiment, the coloring of black color is performed on the translucent portion. Advantageous Effect of Invention

According to the substrate processing apparatus of the present invention, it is possible to save environmental resources.

### Brief Description of Drawings

[FIG. 1] is a schematic view of a substrate processing apparatus according to a preferred embodiment of the present invention.
[FIGS. 2A to 2C] are a view illustrating a recycled material piping that is provided in the substrate processing apparatus according to the preferred embodiment of the present invention (FIG. 2A), a view illustrating a virgin material piping that is provided in the substrate processing apparatus according to the preferred embodiment of the present invention (FIG. 2B), and a view illustrating a cross section of the recycled material piping that is provided in the substrate processing apparatus according to the preferred embodiment of the present invention (FIG. 2C).
[FIG. 3] is a sectional view schematically illustrating an arrangement of a substrate processing portion included in the substrate processing apparatus according to the preferred embodiment of the present invention.
[FIG. 4] is a view illustrating a portion of the arrangement of the substrate processing apparatus according to the preferred embodiment of the present invention.
[FIGS. 5A and 5B] are a view illustrating one example of a recycled material piping (FIG. 5A) and a view illustrating another example of the recycled material piping (FIG. 5B).
[FIGS. 6A to 6C] are a view illustrating a first modification example of the marking portion (FIG. 6A), a view illustrating a second modification example of the marking portion (FIG. 6B), and a view illustrating a third modification example of the marking portion (FIG. 6C).
[FIGS. 7A and 7B] are a view illustrating an example in which an entirety of the recycled material piping or the virgin material piping is colored and the marking portion is formed (FIG. 7A) and a view illustrating an example in which an entirety of the recycled material piping or the virgin material piping is colored and the marking portion is not formed (FIG. 7B).

### Description of Embodiments

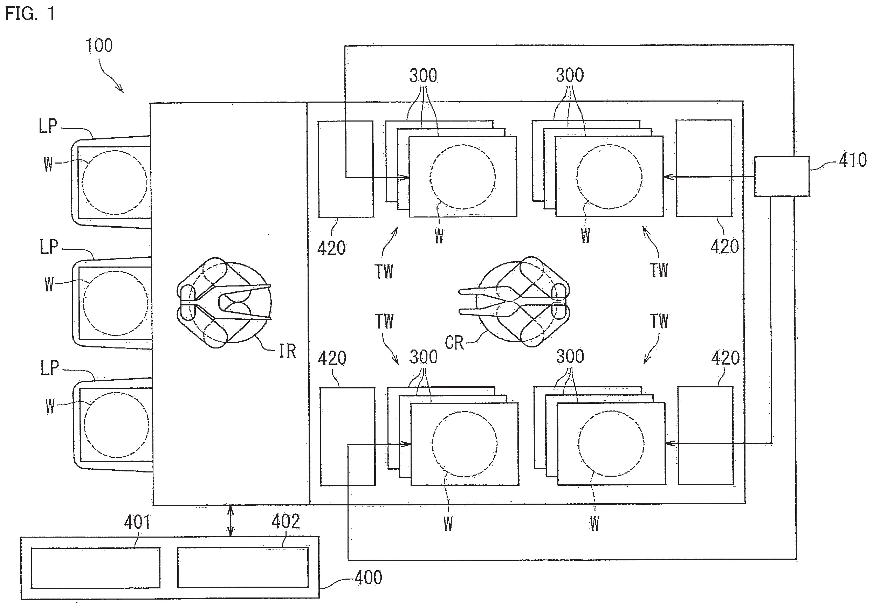

Hereinafter, a preferred embodiment according to a substrate processing apparatus of the present invention shall be described with reference to the drawings (FIG. 1 to FIG. 7B). However, the present invention is not restricted to the preferred embodiments described below and can be implemented in various modes within a scope not deviating from its gist. It is noted that, for portions for which description is redundant, the description is at times omitted as appropriate. Also, in the figures, same or corresponding portions are provided with the same reference sign and description shall not be repeated.

As a "substrate" that becomes a target of substrate processing in the substrate processing apparatus according to the present invention, any of various substrates such as semiconductor wafers, glass substrates for photomasks, glass substrates for liquid crystal displays, glass substrates for plasma displays, substrates for FEDs (field emission displays), substrates for optical disks, substrate for magnetic disks, substrates for magnetooptical disks, etc., is applicable. Although the preferred embodiments of the present invention shall mainly be described below with a case where a disk-shaped semiconductor wafer is a target of the substrate processing as an example, application to any of the various substrates other than the semiconductor wafer described above. Also, a shape of the substrate is not restricted to the disk shape, and the substrate processing apparatus according to the present invention is applicable to substrates having various shapes.

FIG. 1 is a schematic view of a substrate processing apparatus 100 according to the present preferred embodiment. In detail, FIG. 1 is a schematic plan view of the substrate processing apparatus 100 according to the present preferred embodiment. The substrate processing apparatus 100 processes substrates W. The substrate processing apparatus 100 according to the present preferred embodiment is a single substrate processing type apparatus and processes the substrates W one by one using a processing liquid. The substrate processing apparatus 100 is, for example, a cleaning apparatus or an etching apparatus.

As illustrated in FIG. 1, the substrate processing apparatus 100 includes a plurality of substrate processing portions 300, a fluid cabinet 410, a plurality of fluid boxes 420, a plurality of load ports LP, an indexer robot IR, a center robot CR, and a controller 400.

Each of the load ports LP houses a plurality of substrates W in a stacked state. The indexer robot IR transfers the substrate W between the load ports LP and the center robot CR. The center robot CR transfers the substrate W between the indexer robot IR and the substrate processing portions 300. It is noted that a mount (pass) on which the substrate W is temporarily placed may be provided between the indexer robot IR and the center robot CR, and the substrate W may be indirectly delivered between the indexer robot IR and the center robot CR via the mount.

The plurality of substrate processing portions 300 form a plurality of towers TW (four towers TW in FIG. 1). The plurality of towers TW are disposed such as to surround the center robot CR in plan view. Each tower TW includes a plurality of substrate processing portions 300 (three substrate processing portions 300 in FIG. 1) which are stacked vertically.

The fluid cabinet 410 houses a fluid. The fluid includes a processing liquid. Alternatively, the fluid may include the processing liquid and a gas or may include just a gas. In the present preferred embodiment, the fluid cabinet 410 houses the processing liquid and the gas. The gas includes, for example, an inert gas. The inert gas is, for example, nitrogen gas. The processing liquid is not restricted in particular as long as the processing liquid is a liquid that is brought into contact with the substrate W. The processing liquid may include, for example, a chemical liquid and a rinse liquid.

The chemical liquid includes, for example, dilute hydrofluoric acid (DHF), hydrofluoric acid (HF), hydrofluoric nitric acid (a mixture liquid of hydrofluoric acid and nitric acid (HNO₃), buffered hydrofluoric acid (BHF), ammonium fluoride, HFEG (a mixture liquid of hydrofluoric acid and ethylene glycol), phosphoric acid (H₃PO₄), sulfuric acid, acetic acid, nitric acid, hydrochloric acid, ammonia water, hydrogen peroxide water, an organic acid (for example, citric acid, oxalic acid), an organic alkali (for example, TMAH: tetramethylammonium hydroxide), a mixture liquid of sulfuric acid and hydrogen peroxide water (SPM), a mixture liquid of ammonia and hydrogen peroxide water (SC1), a mixture liquid of hydrochloric acid and hydrogen peroxide water (SC2), isopropyl alcohol (IPA), methanol, ethanol, hydrofluoroether (HFE), a surfactant, or a corrosion inhibitor.

The rinse liquid is, for example, pure water (DIW; deionized water). In other words, the rinse liquid can be so-called "ultrapure water." However, the rinse liquid is not restricted to the deionized water. The rinse liquid can be, for example, carbonated water, electrolyzed ion water, hydrogen water, ozone water, ammonia water, or a diluted aqueous hydrochloric acid solution (for example, an aqueous hydrochloric acid solution having a concentration of approximately 10 ppm to 100 ppm).

Each fluid box 420 corresponds to one of the plurality of towers TW. The processing liquid and the gas in the fluid cabinet 410 are supplied via one of the fluid boxes 420 to all of the substrate processing portions 300 included in the corresponding tower TW. That is, the fluid cabinet 410 houses a fluid to be supplied to the substrate processing portions 300.

Each substrate processing portion 300 executes substrate processing on the substrate W. In the present preferred embodiment, the substrate processing portion 300 processes the substrate W using the processing liquid. For example, each substrate processing portion 300 performs etching processing or cleaning processing on the substrate W.

The controller 400 controls operations of respective portions of the substrate processing apparatus 100. For example, the controller 400 controls the substrate processing portions 300, the load ports LP, the indexer robot IR, and the center robot CR. The controller 400 includes a controlling portion 401 and a storage portion 402.

The controlling portion 401 controls the operations of the respective portions of the substrate processing apparatus 100 based on various items of information stored in the storage portion 402. The controlling portion 401 has, for example, a processor. The controlling portion 401 may have a CPU (central processing unit) or an MPU (micro processing unit) as the processor. Alternatively, the controlling portion 401 may have a general-purpose processing unit or a dedicated processor.

The storage portion 402 stores various items of information for controlling operation of the substrate processing apparatus 100. For example, the storage portion 402 stores various items of data and various computer programs. The various items of data include recipe data. The recipe data indicates a recipe that prescribes processing details, processing conditions, and a processing procedure of the substrate W. In the recipe, various setting values are set as the processing conditions.

The storage portion 402 has a main storage device. The main storage device includes, for example, a semiconductor memory. The storage portion 402 may further have an auxiliary storage device. The auxiliary storage device includes, for example, at least one of a semiconductor memory and a hard disk drive. The storage portion 402 may include a removable medium.

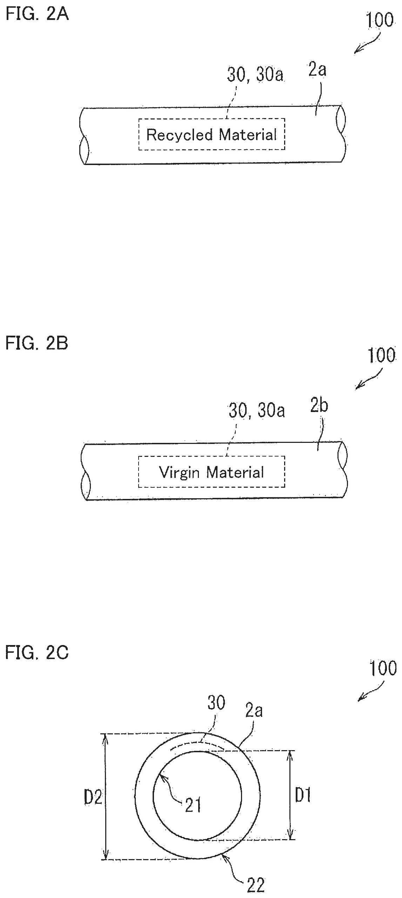

Next, with reference to FIG. 2A to FIG. 2C, a recycled material piping 2a and a virgin material piping 2b provided in the substrate processing apparatus 100 of the present preferred embodiment shall be described. FIG. 2A is a view illustrating the recycled material piping 2a provided in the substrate processing apparatus 100 of the present preferred embodiment. FIG. 2B is a view illustrating the virgin material piping 2b provided in the substrate processing apparatus 100 of the present preferred embodiment.

As illustrated in FIG. 2A, the substrate processing apparatus 100 includes the recycled material piping 2a. Also, as illustrated in FIG. 2B, the substrate processing apparatus 100 includes the virgin material piping 2b. The recycled material piping 2a and the virgin material piping 2b are tubular members that make a fluid flow. Specifically, the recycled material piping 2a makes a processing liquid or a gas flow. Similarly, the virgin material piping 2b makes the processing liquid or the gas flow.

The recycled material piping 2a contains a recycled material of fluororesin. Specifically, a tube molded product manufactured using the recycled material of fluororesin may be used for the recycled material piping 2a. That is, the recycled material piping 2a may be constituted of the recycled material of fluororesin.

The virgin material piping 2b contains a virgin material of fluororesin. Specifically, a tube molded product manufactured using the virgin material of fluororesin may be used for the virgin material piping 2b. That is, the virgin material piping 2b may be constituted of the virgin material of fluororesin. It is noted that the virgin material of fluororesin indicates a new product of fluororesin.

Fluororesin is, for example, polytetrafluoroethylene (PTFE), a tetrafluoroethylene-perfluoroalkoxyethylene copolymer (PFA), a tetrafluoroethylene-hexafluoropropylene copolymer (FEP), or a tetrafluoroethylene-ethylene copolymer (ETFE). For example, a recycled material of PFA is used for the recycled material piping 2a that makes the processing liquid flow. A recycled material of PFA or PTFE is used for the recycled material piping 2a that makes the gas flow. Similarly, a virgin material of PFA is used for the virgin material piping 2b that makes the processing liquid flow. A virgin material of PFA or PTFE is used for the virgin material piping 2b that makes the gas flow.

As illustrated in FIG. 2A, in the present preferred embodiment, the recycled material piping 2a has a marking portion 30. The marking portion 30 includes a first marking 30a to identify the recycled material piping 2a and the virgin material piping 2b. In other words, marking to identify the recycled material piping 2a and the virgin material piping 2b is performed on the marking portion 30. That is, the marking to identify the recycled material piping 2a and the virgin material piping 2b is performed on the recycled material piping 2a. In detail, marking that enables the recycled material piping 2a and the virgin material piping 2b to be visually identified is performed on the recycled material piping 2a.

The marking portion 30 indicates a letter or a number, for example. Alternatively, the marking portion 30 may indicate a mark such as a symbol, a figure, or an emoji. FIG. 2A illustrates a case where the first marking 30a is letters indicating "Recycled Material." The marking portion 30 may be formed on the recycled material piping 2a by laser processing, for example. A broken-line rectangle in FIG. 2A represents a region including the marking portion 30. The same applies to other drawings such as FIG. 2B. The rectangle is an example of a boundary line surrounding the first marking 30a including one or more marks. Such a boundary line may be a line that can be visually identified or may be a virtual line that does not actually exist. In the former case, the boundary line may or may not be a portion of the marking portion 30.

According to the present preferred embodiment, the marking to identify the recycled material piping 2a and the virgin material piping 2b is performed on the recycled material piping 2a. Therefore, it is made possible to visually identify the recycled material piping 2a and the virgin material piping 2b. As a result, for example, at the time of assembling the substrate processing apparatus 100, it is possible to reduce a possibility that the virgin material piping 2b is mistakenly installed at a location at which the recycled material piping 2a is to be installed. Similarly, it is possible to reduce a possibility that the recycled material piping 2a is mistakenly installed at a location at which the virgin material piping 2b is to be installed. Also, at the time of maintenance of the substrate processing apparatus 100, it is possible to reduce a possibility that the recycled material piping 2a is mistakenly replaced with the virgin material piping 2b. Similarly, it is possible to reduce a possibility that the virgin material piping 2b is mistakenly replaced with the recycled material piping 2a.

It is noted that, since a color of a tube molded product made of fluororesin used for a piping of the substrate processing apparatus 100 is transparent, it is difficult to visually identify the recycled material piping 2a and the virgin material piping 2b. Therefore, in a case where the marking to identify the recycled material piping 2a and the virgin material piping 2b is not performed on the recycled material piping 2a, at the time of assembling the substrate processing apparatus 100, there is the possibility that the virgin material piping 2b is mistakenly installed at a location at which the recycled material piping 2a is to be installed. Similarly, there is the possibility that the recycled material piping 2a is mistakenly installed at a location at which the virgin material piping 2b is to be installed. Also, at the time of maintenance of the substrate processing apparatus 100, there is the possibility that the recycled material piping 2a is mistakenly replaced with the virgin material piping 2b. Similarly, there is the possibility that the virgin material piping 2b is mistakenly replaced with the recycled material piping 2a.

As illustrated in FIG. 2B, in the present preferred embodiment, as with the recycled material piping 2a, the virgin material piping 2b has the marking portion 30. The marking portion 30 includes the first marking 30a. Therefore, marking to identify the recycled material piping 2a and the virgin material piping 2b is performed on the virgin material piping 2b. FIG. 2B illustrates a case where the first marking 30a is letters indicating "Virgin Material."

According to the present preferred embodiment, marking to identify the recycled material piping 2a and the virgin material piping 2b is performed on both the recycled material piping 2a and the virgin material piping 2b. Therefore, it is made possible to visually identify the recycled material piping 2a and the virgin material piping 2b more reliably.

FIG. 2C is a view illustrating a cross section of the recycled material piping 2a provided in the substrate processing apparatus 100 of the present preferred embodiment. In FIG. 2C, hatching of the recycled material piping 2a is omitted. As illustrated in FIG. 2C, the recycled material piping 2a is a tubular member consisting of one layer of fluororesin. An inner diameter D1 of the recycled material piping 2a is 4 [mm], for example. An outer diameter D2 of the recycled material piping 2a is 6 [mm], for example. A wall thickness of the recycled material piping 2a is 1 [mm], for example. The recycled material piping 2a has an inner surface 21 and an outer surface 22, and a fluid (a processing liquid or a gas) flows on an inner side of the inner surface 21. It is noted that, since an arrangement of the virgin material piping 2b is the same as the recycled material piping 2a, the description thereof shall be omitted.

As illustrated in FIG. 2C, the recycled material piping 2a has the marking portion 30 between the inner surface 21 and the outer surface 22. Therefore, the marking portion 30 is an inner marking. In other words, the inner marking is performed on the recycled material piping 2a. The marking portion 30 (the inner marking) may be formed by, for example, adjusting a focal point of laser light between the inner surface 21 and the outer surface 22 during laser processing. It is noted that, as with the recycled material piping 2a, the marking portion 30 of the virgin material piping 2b is also an inner marking.

According to the present preferred embodiment, the marking portion 30 is formed between the inner surface 21 and the outer surface 22. Therefore, it is possible to suppress generation of particles as compared with a piping with the marking portion 30 formed on the inner surface 21.

Specifically, in a case where the marking portion 30 is formed on the inner surface 21 by laser processing, carbide is formed on the inner surface 21. As a result, there is a possibility that the carbide is mixed into the fluid flowing on the inner side of the inner surface 21. Therefore, there is a possibility that the fluid in which the carbide is mixed comes into contact with the substrate W and the number of particles on the substrate W increases. On the other hand, according to the present preferred embodiment, the marking portion 30 is formed between the inner surface 21 and the outer surface 22. Therefore, the possibility that the carbide formed by laser processing is mixed into the fluid flowing on the inner side of the inner surface 21 is low. Thus, it is possible to suppress an increase in the number of particles on the substrate W.

Also, according to the present preferred embodiment, as compared with a case where the marking portion 30 is formed on the outer surface 22, it is possible to reduce a possibility that the fluid leaks from a joint which connects the recycled material piping 2a and another recycled material piping 2a. That is, it is possible to improve the sealing performance as compared with a piping with the marking portion 30 formed on the outer surface 22. Similarly, the virgin material piping 2b can also improve the sealing performance.

Specifically, in a case where the marking portion 30 is formed on the outer surface 22 by laser processing, unevenness is formed on the outer surface 22. As a result, there is a possibility that unevenness is formed on the outer surface 22 at one end portion of the piping which is to be inserted into the joint. In a case where unevenness is formed on the outer surface 22 of the one end portion of the piping which is to be inserted into the joint, there is a possibility that the fluid leaks from the joint via the unevenness. On the other hand, according to the present preferred embodiment, the marking portion 30 is formed between the inner surface 21 and the outer surface 22. Therefore, since unevenness is not formed on the outer surface 22 at one end portion of the recycled material piping 2a which is to be inserted into the joint, it is possible to reduce a possibility that the fluid leaks from the joint. Similarly, the virgin material piping 2b can reduce the possibility that the fluid leaks from the joint.

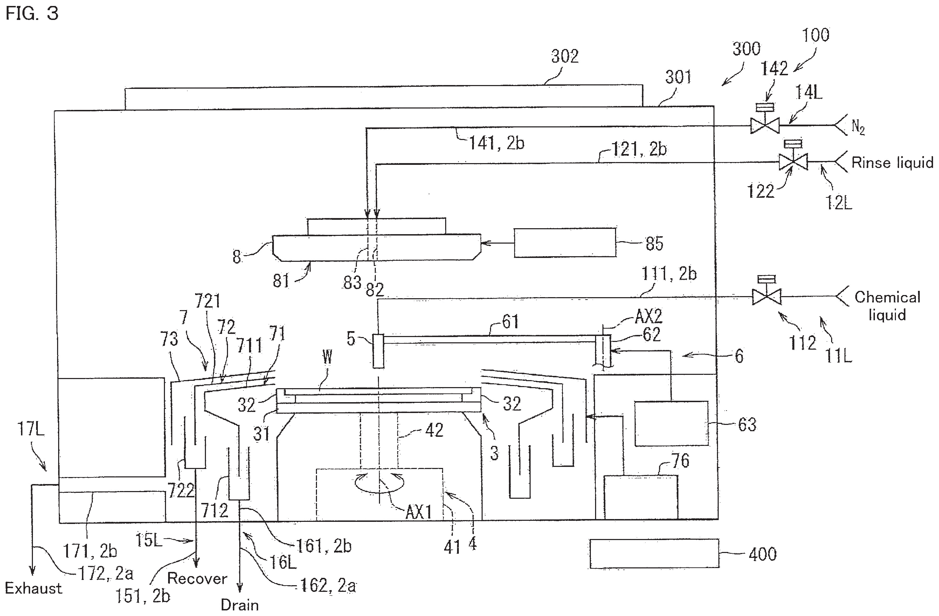

Next, the substrate processing apparatus 100 of the present preferred embodiment shall be described with reference to FIG. 3. FIG. 3 is a sectional view schematically illustrating an arrangement of the substrate processing portion 300 included in the substrate processing apparatus 100 of the present preferred embodiment.

As illustrated in FIG. 3, the substrate processing portion 300 has a chamber 301, an FFU (fan filter unit) 302, a spin chuck 3, a spin motor portion 4, a first nozzle 5, a nozzle moving portion 6, a liquid receiving portion 7, a blocking member 8, a first elevating/lowering portion 76, and a second elevating/lowering portion 85. The substrate processing apparatus 100 further includes a first processing liquid line 11L, a second processing liquid line 12L, a first gas line 14L, a recovery line 15L, a drain line 16L, and an exhaust line 17L.

The chamber 301 has a substantially box shape. The chamber 301 houses the spin chuck 3, the spin motor portion 4, the first nozzle 5, the nozzle moving portion 6, the liquid receiving portion 7, the blocking member 8, the first elevating/lowering portion 76, the second elevating/lowering portion 85, a portion of the first processing liquid line 11L, a portion of the second processing liquid line 12L, a portion of the first gas line 14L, a portion of the recovery line 15L, a portion of the drain line 16L, and a portion of the exhaust line 17L.

The substrate W is carried into the chamber 301. Therefore, the chamber 301 houses the substrate W. The substrate W is processed in the chamber 301.

The FFU 302 is disposed outside the chamber 301. The FFU 302 blows air toward an inner space of the chamber 301 and generate a downflow in the chamber 301.

More specifically, the FFU 302 blows, toward the inner space of the chamber 301, air in a clean room in which the substrate processing apparatus 100 is installed. In detail, the FFU 302 has blades, an electric motor, and a filter. The blades suck the air in the cleanroom by rotating and blow the sucked air toward the inner space of the chamber 301. The electric motor rotates the blades. The filter filters the air sent by the rotating blades. As a result, the air cleaned by the filter is blown toward the inner space of the chamber 301.

The spin chuck 3 holds the substrate W in a horizontal orientation. As illustrated in FIG. 3, the spin chuck 3 may have a spin base 31 and a plurality of chuck members 32. The spin base 31 has a substantially disk shape and supports the plurality of chuck members 32 in a horizontal orientation. The plurality of chuck members 32 are disposed on a peripheral edge portion of the spin base 31. The plurality of chuck members 32 clamps a peripheral edge portion of the substrate W. The substrate W is held in a horizontal orientation by the plurality of chuck members 32. Operation of the plurality of chuck members 32 is controlled by the controller 400 (the controlling portion 401).

The spin motor portion 4 integrally rotates the spin chuck 3 and the substrate W centered at a first rotational axis AX1 extending in a vertical direction. The controller 400 (the controlling portion 401) controls the rotation of the substrate W by the spin motor portion 4. In detail, the first rotational axis AX1 passes through a center of the spin base 31. The plurality of chuck members 32 are disposed such that a center of the substrate W faces the center of the spin base 31. Therefore, the substrate W rotates around the center of the substrate W as the rotation center.

As illustrated in FIG. 3, the spin motor portion 4 may have a motor main body 41 and a shaft 42. The shaft 42 is coupled to the spin base 31. The motor main body 41 rotates the shaft 42. As a result, the spin base 31 rotates. Operation of the motor main body 41 is controlled by the controller 400 (the controlling portion 401).

The first nozzle 5 discharges a chemical liquid from a position above the substrate W held by the spin chuck 3 toward an upper surface of the rotating substrate W. The chemical liquid is discharged onto the upper surface of the rotating substrate W, and a liquid film of the chemical liquid is thereby formed on the upper surface of the substrate W. As a result, the upper surface of the substrate W is processed with the chemical liquid.

The first processing liquid line 11L supplies the chemical liquid to the first nozzle 5. As illustrated in FIG. 3, the first processing liquid line 11L has a first liquid supply piping 111 and a first opening-closing valve 112.

The first liquid supply piping 111 is a tubular member through which the processing liquid (liquid) flows. The first liquid supply piping 111 supplies the chemical liquid (liquid) to the substrate processing portion 300. More specifically, first liquid supply piping 111 makes the chemical liquid flow to the first nozzle 5.

One portion of the first liquid supply piping 111 is housed in the chamber 301. The other portion of the first liquid supply piping 111 is housed in the fluid box 420 described with reference to FIG. 1. In other words, a portion of the first liquid supply piping 111 is disposed inside the chamber 301, and the other portion of the first liquid supply piping 111 is disposed outside the chamber 301. In the present preferred embodiment, the virgin material piping 2b described with reference to FIG. 2B and FIG. 2C is used for the first liquid supply piping 111.

The first opening-closing valve 112 is interposed in the first liquid supply piping 111. The first opening-closing valve 112 is housed in the fluid box 420 described with reference to FIG. 1. The first opening-closing valve 112 can switch between an open state and a closed state. The controller 400 (the controlling portion 401) controls opening/closing operation of the first opening-closing valve 112. An actuator of the first opening-closing valve 112 is, for example, a pneumatic actuator.

The first opening-closing valve 112 controls flow and stop of the flow of the chemical liquid (liquid) via the first liquid supply piping 111. In other words, the first opening-closing valve 112 controls supply and stop of the supply of the chemical liquid to the first nozzle 5.

The controller 400 (the controlling portion 401) puts the first opening-closing valve 112 in the open state when supplying the chemical liquid to the substrate W. As a result, the chemical liquid flows through the first liquid supply piping 111 toward the first nozzle 5, and the chemical liquid is discharged from the first nozzle 5 toward the substrate W.

The controller 400 (the controlling portion 401) puts the first opening-closing valve 112 in the closed state when stopping discharge of the chemical liquid from the first nozzle 5. As a result, the flow of the chemical liquid via the first liquid supply piping 111 is stopped, and the discharge of the chemical liquid from the first nozzle 5 is stopped.

The nozzle moving portion 6 moves the first nozzle 5 along a horizontal plane. The nozzle moving portion 6 is controlled by the controller 400 (the controlling portion 401). In more detail, the nozzle moving portion 6 moves the first nozzle 5 between a first retracted position and a processing position. The first retracted position is a position on an outer side of the spin chuck 3. For example, the first retracted position may be a position on an outer side of the liquid receiving portion 7. In the present preferred embodiment, the processing position is a position facing the center of the substrate W. The first nozzle 5 discharges the chemical liquid from the processing position toward the substrate W.

As illustrated in FIG. 3, the nozzle moving portion 6 may have a nozzle arm 61, a nozzle base 62, and a nozzle moving mechanism 63. The nozzle base 62 extends in the vertical direction. A proximal end portion of the nozzle arm 61 is coupled to the nozzle base 62. The nozzle arm 61 extends horizontally from the nozzle base 62. The nozzle arm 61 supports the first nozzle 5. The first nozzle 5 projects vertically downward from the nozzle arm 61.

The nozzle moving mechanism 63 rotates the nozzle base 62 in both forward and reverse directions centered at a second rotational axis AX2 extending in the vertical direction. As a result, the first nozzle 5 moves along a circumferential direction centered at the second rotational axis AX2. The nozzle moving mechanism 63 is controlled by the controller 400 (the controlling portion 401). An actuator of the nozzle moving mechanism 63 may have, for example, an electric motor rotatable in both the forward and reverse directions and a speed reducer.

The blocking member 8 is positioned above the substrate W held by the spin chuck 3. A lower surface 81 of the blocking member 8 faces the upper surface of the substrate W held by the spin chuck 3. The lower surface 81 has, for example, a circular shape. The size of a diameter of the lower surface 81 is equal to or larger than a diameter of the substrate W and is smaller than an inner diameter of the liquid receiving portion 7. In FIG. 3, hatching of the blocking member 8 is omitted.

The second elevating/lowering portion 85 elevates and lowers the blocking member 8 between a second retracted position and a blocking position. The blocking position is a position lower than the second retracted position. Specifically, the blocking position is a position closer to the substrate W held by the spin chuck 3 as compared with the second retracted position. FIG. 3 illustrates the blocking member 8 positioned at the second retracted position.

When the blocking member 8 is moved from the second retracted position to the blocking position, a processing space is formed by the liquid receiving portion 7 and the blocking member 8. The processing space is a space substantially blocked from an atmosphere outside the processing space. That is, the processing space is a local space formed inside the chamber 301. The processing space is substantially blocked from an atmosphere inside the chamber 301.

The second elevating/lowering portion 85 is controlled by the controller 400 (the controlling portion 401). An actuator of the second elevating/lowering portion 85 includes, for example, an electric motor rotatable in both forward and reverse directions and a ball screw mechanism.

As illustrated in FIG. 3, the blocking member 8 has a second nozzle 82 and a third nozzle 83. Discharge ports of the second nozzle 82 and the third nozzle 83 are open in the lower surface 81 of the blocking member 8. The discharge ports of the second nozzle 82 and the third nozzle 83 may be disposed at positions facing a central portion of the substrate W held by the spin chuck 3. The second nozzle 82 discharges the rinse liquid toward the upper surface of the substrate W. The third nozzle 83 discharges an inert gas. In the present preferred embodiment, through the third nozzle 83 discharges nitrogen gas.

The second processing liquid line 12L supplies the rinse liquid to the second nozzle 82. As illustrated in FIG. 3, the second processing liquid line 12L has a second liquid supply piping 121 and a second opening-closing valve 122. The second liquid supply piping 121 supplies the rinse liquid (liquid) to the substrate processing portion 300. More specifically, the second liquid supply piping 121 makes the rinse liquid flow to the second nozzle 82. In the present preferred embodiment, the virgin material piping 2b described with reference to FIG. 2B and FIG. 2C is used for the second liquid supply piping 121. Since an arrangement of the second processing liquid line 12L is substantially the same as the first processing liquid line 11L, the detailed description thereof shall be omitted.

The first gas line 14L supplies inert gas to the third nozzle 83. In the present preferred embodiment, the first gas line 14L supplies nitrogen gas to the third nozzle 83. As illustrated in FIG. 3, the first gas line 14L has a first gas piping 141 and a third opening-closing valve 142. The first gas piping 141 supplies the inert gas (gas) to the substrate processing portion 300. More specifically, the first gas piping 141 makes the inert gas (gas) flow to the third nozzle 83. In the present preferred embodiment, the virgin material piping 2b described with reference to FIG. 2B and FIG. 2C is used for the first gas piping 141. Since an arrangement of the first gas line 14L is substantially the same as the first processing liquid line 11L, the detailed description thereof shall be omitted.

The liquid receiving portion 7 receives the chemical liquid expelled from the substrate W. The liquid receiving portion 7 further receives the rinse liquid expelled from the substrate W. In detail, the liquid receiving portion 7 includes a first liquid receiving portion 71 and a second liquid receiving portion 72. The first liquid receiving portion 71 is disposed on an inner side of the second liquid receiving portion 72. The first liquid receiving portion 71 receives the rinse liquid expelled from the substrate W. The second liquid receiving portion 72 receives the chemical liquid expelled from the substrate W.

As illustrated in FIG. 3, the first liquid receiving portion 71 has a first guard portion 711 and a first cup portion 712. The second liquid receiving portion 72 has a second guard portion 721 and a second cup portion 722.

The first guard portion 711 has a substantially cylindrical shape surrounding the spin chuck 3 and the spin motor portion 4 and is disposed around the spin chuck 3 and the spin motor portion 4. The first guard portion 711 receives the rinse liquid that scatters from the rotating substrate W.

The first cup portion 712 forms an annular groove below a lower end of the first guard portion 711. The rinse liquid flowing down from an inner peripheral surface of the first guard portion 711 is collected in the first cup portion 712.

The second guard portion 721 has a substantially cylindrical shape surrounding the first guard portion 711 and is disposed around the first guard portion 711. The second guard portion 721 receives the chemical liquid that scatters from the rotating substrate W.

The second cup portion 722 forms an annular groove below a lower end of the second guard portion 721. The chemical liquid flowing down from an inner peripheral surface of the second guard portion 721 is collected in the second cup portion 722.

It is noted that, as illustrated in FIG. 3, the liquid receiving portion 7 further has a third liquid receiving portion 73. The third liquid receiving portion 73 is a guard portion. The detailed description of the third liquid receiving portion 73 shall be omitted.

The first elevating/lowering portion 76 individually elevates and lowers the first guard portion 711, the second guard portion 721, and the third liquid receiving portion 73 (guard portion). The first elevating/lowering portion 76 is controlled by the controller 400 (the controlling portion 401). Specifically, the first elevating/lowering portion 76 individually elevates and lowers the first guard portion 711, the second guard portion 721, and the third liquid receiving portion 73 (guard portion) between a liquid receiving position and a third retracted position. The liquid receiving position is a position higher than the third retracted position. The first elevating/lowering portion 76 includes, for example, an electric motor rotatable in both forward and reverse directions and a ball screw mechanism. FIG. 3 illustrates the first guard portion 711, the second guard portion 721, and the third liquid receiving portion 73 (guard portion) positioned at the liquid receiving position.

The drain line 16L expels the rinse liquid collected in the first cup portion 712 to the outside of the substrate processing portion 300 (the chamber 301). For example, the drain line 16L guides the rinse liquid collected in the first cup portion 712 to a piping that is connected to waste liquid equipment of a plant where the substrate processing apparatus 100 is installed. That is, the drain line 16L expels the rinse liquid collected in the first cup portion 712 to the outside of the substrate processing apparatus 100. Alternatively, the drain line 16L may expel the rinse liquid collected in the first cup portion 712 to a drain tank disposed outside the substrate processing portion 300 or may expel to the outside of the substrate processing apparatus 100 via the drain tank.

As illustrated in FIG. 3, the drain line 16L has a first drain piping 161 and a second drain piping 162. The first drain piping 161 and the second drain piping 162 are tubular members through which the processing liquid (liquid) flows.

The first drain piping 161 is housed in the chamber 301. In other words, the first drain piping 161 is disposed inside the chamber 301. One end of the first drain piping 161 is connected to a bottom portion of the first cup portion 712. As a result, the rinse liquid collected in the first cup portion 712 flows into the first drain piping 161. In the present preferred embodiment, the virgin material piping 2b described with reference to FIG. 2B and FIG. 2C is used for the first drain piping 161.

The second drain piping 162 is disposed outside the chamber 301. An upstream end of the second drain piping 162 is connected to a downstream end of the first drain piping 161. Therefore, the rinse liquid flows from the first drain piping 161 into the second drain piping 162. As a result, the rinse liquid (liquid) expelled from the substrate processing portion 300 flows through the second drain piping 162. For example, the downstream end of the first drain piping 161 and the upstream end of the second drain piping 162 may be connected via a joint. In the present preferred embodiment, the recycled material piping 2a described with reference to FIG. 2A and FIG. 2C is used for the second drain piping 162.

The second drain piping 162 makes the rinse liquid flowed into the second drain piping 162 via the first drain piping 161 flow to the piping that is connected to the waste liquid equipment of the plant where the substrate processing apparatus 100 is installed. That is, the second drain piping 162 makes the rinse liquid collected in the first cup portion 712 flow to the outside of the substrate processing apparatus 100. Alternatively, the second drain piping 162 may make the rinse liquid flowed into the second drain piping 162 via the first drain piping 161 flow to a drain tank that is disposed outside the substrate processing portion 300 or flow to the outside of the substrate processing apparatus 100 via the drain tank.

The recovery line 15L guides the chemical liquid collected in the second cup portion 722 to the outside of the substrate processing portion 300 (the chamber 301). More specifically, the recovery line 15L guides the chemical liquid collected in the second cup portion 722 to the fluid cabinet 410 described with reference to FIG. 1. As a result, the chemical liquid collected in the second cup portion 722 is collected in the fluid cabinet 410.

As illustrated in FIG. 3, the recovery line 15L has a recovery piping 151. The recovery piping 151 is a tubular member through which the processing liquid (liquid) flows. One end of the recovery piping 151 is connected to a bottom portion of the second cup portion 722. Therefore, the chemical liquid collected in the second cup portion 722 flows into the recovery piping 151.

At least a portion of the recovery piping 151 is disposed outside the chamber 301. In the present preferred embodiment, a portion of the recovery piping 151 is housed in the chamber 301. In other words, a portion of the recovery piping 151 is disposed inside the chamber 301, and the other portion of the recovery piping 151 is disposed outside the chamber 301.

The recovery piping 151 makes the chemical liquid flowed in from the second cup portion 722 flow to the fluid cabinet 410 described with reference to FIG. 1. That is, the recovery piping 151 makes the chemical liquid (liquid), which is expelled from the substrate processing portion 300, flow to the fluid cabinet 410. In the present preferred embodiment, the virgin material piping 2b described with reference to FIG. 2B and FIG. 2C is used for the recovery piping 151.

The exhaust line 17L expels the gas in the chamber 301 to the outside of the chamber 301. Specifically, the exhaust line 17L has a first exhaust piping 171 and a second exhaust piping 172. The first exhaust piping 171 and the second exhaust piping 172 are tubular members through which a gas flows.

The first exhaust piping 171 is housed in the chamber 301. In other words, the first exhaust piping 171 is disposed inside the chamber 301. One end of the first exhaust piping 171 communicates with the inner space of the chamber 301 at a position lower than the spin chuck 3. In the present preferred embodiment, the virgin material piping 2b described with reference to FIG. 2B and FIG. 2C is used for the first exhaust piping 171.

The second exhaust piping 172 is disposed outside the chamber 301. An upstream end of the second exhaust piping 172 is connected to a downstream end of the first exhaust piping 171. For example, the downstream end of the first exhaust piping 171 and the upstream end of the second exhaust piping 172 may be connected via a joint. In the present preferred embodiment, the recycled material piping 2a described with reference to FIG. 2A and FIG. 2C is used for the second exhaust piping 172.

Gases in the first exhaust piping 171 and the second exhaust piping 172 are constantly sucked by exhaust equipment (not illustrated) provided in the plant in which the substrate processing apparatus 100 is installed. Therefore, when the substrate W is processed with the chemical liquid, a chemical liquid atmosphere in the chamber 301 is sucked to an upstream end of the first exhaust piping 171 by a suction force of the exhaust equipment which is transmitted through the exhaust line 17L. As a result, the chemical liquid atmosphere in the chamber 301 is expelled to the outside of the substrate processing portion 300 (the chamber 301) through the exhaust line 17L. Similarly, when the processing space is formed by the blocking member 8 and the liquid receiving portion 7, the inert gas (nitrogen gas) introduced into the processing space is expelled to the outside of the substrate processing portion 300 (the chamber 301) through the exhaust line 17L.

Next, with reference to FIG. 3, substrate processing performed by the substrate processing apparatus 100 of the present preferred embodiment shall be described. First, the controller 400 (the controlling portion 401) controls the center robot CR described with reference to FIG. 1 to carry the to-be-processed substrate W into the chamber 301. Then, the controller 400 (the controlling portion 401) controls the spin chuck 3 such that the spin chuck 3 holds the substrate W carried in by the center robot CR.

When the substrate W is held by the spin chuck 3, the controller 400 (the controlling portion 401) controls the spin motor portion 4 to integrally rotate the spin chuck 3 and the substrate W. Also, the controller 400 (the controlling portion 401) controls the first elevating/lowering portion 76 to move the second guard portion 721 and the third liquid receiving portion 73 (guard portion) from the third retracted position to the liquid receiving position with the first guard portion 711 being positioned as it is at the third retracted position. Then, the controller 400 (the controlling portion 401) controls the nozzle moving portion 6 to move the first nozzle 5 from the first retracted position to the processing position.

After moving the first nozzle 5 to the processing position, the controller 400 (the controlling portion 401) opens the first opening-closing valve 112. When the first opening-closing valve 112 is opened, the chemical liquid is supplied to the first nozzle 5 via the first liquid supply piping 111, and the chemical liquid is discharged from the first nozzle 5 toward the central portion of the rotating substrate W. As a result, the liquid film of the chemical liquid is formed on the upper surface of the substrate W, and the substrate W is processed with the chemical liquid.

The chemical liquid supplied to the rotating substrate W is expelled to the periphery of the substrate W. The chemical liquid expelled from the substrate W is received by the second guard portion 721. The chemical liquid received by the second guard portion 721 flows into the recovery piping 151 via the second cup portion 722. As a result, the chemical liquid expelled from the substrate W is recovered via the recovery line 15L into the fluid cabinet 410 described with reference to FIG. 1.

The controller 400 (the controlling portion 401) closes the first opening-closing valve 112 when a predetermined time elapses from when the discharge of the chemical liquid is started. When the first opening-closing valve 112 is put in the closed state, the flow of the chemical liquid via the first liquid supply piping 111 is stopped, and the discharge of the chemical liquid from the first nozzle 5 is stopped. As a result, processing of the substrate W with the chemical liquid is ended.

After the processing of the substrate W with the chemical liquid is ended, the controller 400 (the controlling portion 401) controls the nozzle moving portion 6 to move the first nozzle 5 from the processing position to the first retracted position.

Upon moving the first nozzle 5 from the processing position to the first retracted position, the controller 400 (the controlling portion 401) controls the second elevating/lowering portion 85 to move the blocking member 8 from the second retracted position to the blocking position and forms the processing space. Also, the controller 400 (the controlling portion 401) controls the first elevating/lowering portion 76 to move the first guard portion 711 from the third retracted position to the liquid receiving position.

After forming the processing space, the controller 400 (the controlling portion 401) opens the third opening-closing valve 142. As a result, the nitrogen gas is supplied from the third nozzle 83 to the processing space, and an atmosphere in the processing space is replaced from an air atmosphere to a nitrogen atmosphere.

After the supply of nitrogen gas is started, the controller 400 (the controlling portion 401) opens the second opening-closing valve 122. When the second opening-closing valve 122 is opened, the rinse liquid is supplied to the second nozzle 82 via the second liquid supply piping 121, and the rinse liquid is discharged from the second nozzle 82 toward the central portion of the rotating substrate W. As a result, the chemical liquid remaining on the substrate W is washed away by the rinse liquid, and a liquid film of the rinse liquid is formed on the upper surface of the substrate W.

The controller 400 (the controlling portion 401) closes the second opening-closing valve 122 when a predetermined time elapses from when the discharge of the rinse liquid is started. When the second opening-closing valve 122 is put in the closed state, the flow of the rinse liquid via the second liquid supply piping 121 is stopped, and the discharge of the rinse liquid from the second nozzle 82 is stopped. As a result, rinse processing is ended.

After the discharge of the rinse liquid is stopped, the controller 400 (the controlling portion 401) controls the spin motor portion 4 to increase a rotation speed of the substrate W and rotate the substrate W at a high speed. By rotating the substrate W at a high speed, the rinse liquid adhering to the substrate W scatters from the substrate W, and the substrate W is dried. When a predetermined time elapses from when the rotation speed of the substrate W is increased, the controller 400 (the controlling portion 401) controls the spin motor portion 4 to stop the rotation of the substrate W. As a result, drying processing is ended.

Hereinafter, pipings disposed inside the chamber 301 may be referred to as "intra-chamber pipings." Also, a piping through which the processing liquid to be supplied to the substrate W flows may be referred to as a "liquid supply piping." The intra-chamber pipings include the first liquid supply piping 111, the second liquid supply piping 121, the first gas piping 141, the recovery piping 151, the first drain piping 161, and the first exhaust piping 171. The liquid supply pipings include the first liquid supply piping 111 and the second liquid supply piping 121.

As described with reference to FIGS. 1 to 3, in the present preferred embodiment, the virgin material piping 2b is used for the intra-chamber piping. Since the virgin material piping 2b is cleaner as compared with the recycled material piping 2a, by using the virgin material piping 2b for the intra-chamber piping, it becomes less likely that an interior of the chamber 301 is contaminated, as compared with a case where the recycled material piping 2a is used for the intra-chamber piping. As a result, it becomes less likely that the number of particles on the substrate W increases, as compared with the case where the recycled material piping 2a is used for the intra-chamber piping.

Also, in the present preferred embodiment, the virgin material piping 2b is used for the liquid supply piping. Since the virgin material piping 2b is cleaner as compared with the recycled material piping 2a, by using the virgin material piping 2b for the liquid supply piping, it becomes less likely that the number of particles on the substrate W increases, as compared with a case where the recycled material piping 2a is used for the liquid supply piping.

Also, in the present preferred embodiment, the virgin material piping 2b is used for the first gas piping 141. Since the virgin material piping 2b is cleaner than the recycled material piping 2a, by using the virgin material piping 2b for the first gas piping 141, it becomes less likely that the interior of the chamber 301 is contaminated, as compared with a case where the recycled material piping 2a is used for the first gas piping 141. As a result, it becomes less likely that the number of particles on the substrate W increases, as compared with the case where the recycled material piping 2a is used for the first gas piping 141.

Also, as described with reference to FIG. 2C, the inner marking is performed on the virgin material piping 2b. Therefore, by using the virgin material piping 2b for the liquid supply piping, it becomes less likely that the carbide is mixed into the processing liquid to be supplied to the substrate W, as compared with a case where the marking portion 30 is formed on the inner surface 21 of the liquid supply piping. Thus, it becomes less likely that the number of particles on the substrate W increases, as compared with the case where the marking portion 30 is formed on the inner surface 21 of the liquid supply piping.

Similarly, by using the virgin material piping 2b for the first gas piping 141, it becomes less likely that the carbide is mixed into the gas to be supplied into the chamber 301, as compared with a case where the marking portion 30 is formed on the inner surface 21 of the first gas piping 141. Thus, it becomes less likely that the interior of the chamber 301 is contaminated, as compared with the case where the marking portion 30 is formed on the inner surface 21 of the first gas piping 141. As a result, it becomes less likely that the number of particles on the substrate W increases, as compared with the case where the marking portion 30 is formed on the inner surface 21 of the first gas piping 141.

Also, in a case where the marking portion 30 is formed on the outer surface 22 of the intra-chamber piping, there is a possibility that the interior of the chamber 301 is contaminated by the carbide which peeled off from the outer surface 22. For example, in a case where the atmosphere in the chamber 301 becomes an acidic atmosphere, the carbide easily peels off from the outer surface 22. On the other hand, according to the present preferred embodiment, the inner marking is performed on the virgin material piping 2b. Therefore, by using the virgin material piping 2b for the intra-chamber piping, it is possible to reduce a possibility that the interior of the chamber 301 is contaminated by the carbide, as compared with the case where the marking portion 30 is formed on the outer surface 22 of the intra-chamber piping. As a result, it becomes less likely that the number of particles on the substrate W increases, as compared with the case where the marking portion 30 is formed on the outer surface 22 of the intra-chamber piping.

Also, according to the present preferred embodiment, the virgin material piping 2b is used for the recovery piping 151. The chemical liquid which flows through the recovery piping 151 is recovered in the fluid cabinet 410 and used again for the substrate processing. Since the virgin material piping 2b is cleaner as compared with the recycled material piping 2a, by using the virgin material piping 2b for the recovery piping 151, it becomes less likely that the number of particles on the substrate W increases, as compared with a case where the recycled material piping 2a is used for the recovery piping 151.

Also, by using the virgin material piping 2b for the recovery piping 151, it becomes less likely that the carbide is mixed into the processing liquid to be supplied to the substrate W, as compared with a case where the marking portion 30 is formed on the inner surface 21 of the recovery piping 151. Thus, it becomes less likely that the number of particles on the substrate W increases, as compared with the case where the marking portion 30 is formed on the inner surface 21 of the recovery piping 151.

Also, according to the present preferred embodiment, the recycled material piping 2a is used for the second drain piping 162 and the second exhaust piping 172. Therefore, the amount of the virgin material of fluororesin used in the substrate processing apparatus 100 can be reduced, as compared with a case where the virgin material piping 2b is used for the second drain piping 162 and the second exhaust piping 172. Thus, it is possible to save environmental resources.

Also, according to the present preferred embodiment, as described with reference to FIG. 2A and FIG. 2B, the marking (the first marking 30a) to identify the recycled material piping 2a and the virgin material piping 2b is performed on the recycled material piping 2a. Therefore, it is made possible to visually identify the recycled material piping 2a and the virgin material piping 2b. As a result, for example, at the time of the assembling or the maintenance of the substrate processing apparatus 100, it is possible to reduce a possibility that the recycled material piping 2a is mistakenly used for the intra-chamber piping.

Also, according to the present preferred embodiment, as described with reference to FIG. 2A and FIG. 2B, as with the recycled material piping 2a, the marking (the first marking 30a) to identify the recycled material piping 2a and the virgin material piping 2b is performed also on the virgin material piping 2b. Therefore, it is made possible to visually identify the recycled material piping 2a and the virgin material piping 2b more reliably.

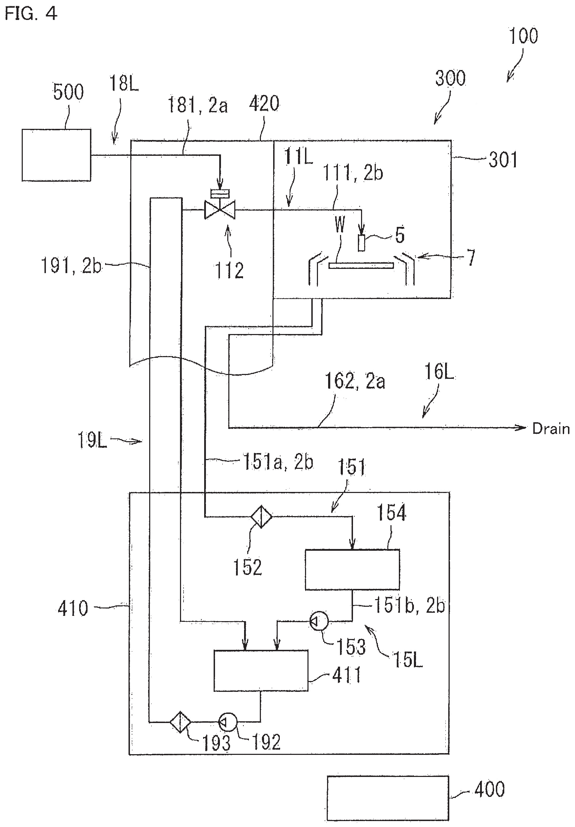

Next, with reference to FIG. 4, the substrate processing apparatus 100 of the present preferred embodiment shall be described. FIG. 4 is a view illustrating a portion of the arrangement of the substrate processing apparatus 100 of the present preferred embodiment. As illustrated in FIG. 4, the substrate processing apparatus 100 further includes a storage tank 411, a recovery tank 154, a second gas line 18L, a circulation line 19L, and a valve driving portion 500.

The storage tank 411 is housed in the fluid cabinet 410. The storage tank 411 stores the chemical liquid. The circulation line 19L circulates the chemical liquid stored in the storage tank 411. Specifically, the circulation line 19L has a circulation piping 191, a circulation pump 192, and a circulation filter 193.

The circulation piping 191 is a tubular member through which the processing liquid (liquid) flows. One end and the other end of the circulation piping 191 are connected to the storage tank 411. A portion of the circulation piping 191 is housed in the fluid cabinet 410. The other portion of the circulation piping 191 is housed in the fluid box 420. In the present preferred embodiment, the virgin material piping 2b is used for the circulation piping 191.

The circulation pump 192 is interposed in the circulation piping 191. The circulation pump 192 is housed in the fluid cabinet 410. The circulation pump 192 feeds the chemical liquid such that the chemical liquid flows in the circulation piping 191 from the one end toward the other end of the circulation piping 191. As a result, the chemical liquid circulates in the circulation piping 191 via the storage tank 411. The circulation pump 192 is controlled by the controller 400 (the controlling portion 401).

The circulation filter 193 is interposed in the circulation piping 191. The circulation filter 193 is housed in the fluid cabinet 410. The circulation filter 193 removes foreign matter from the chemical liquid flowing in the circulation piping 191.

The recovery tank 154 is housed in the fluid cabinet 410. The recovery tank 154 stores the chemical liquid recovered by the recovery line 15L. The recovery line 15L makes the chemical liquid recovered from the liquid receiving portion 7 flow to the storage tank 411 via the recovery tank 154. Specifically, the recovery line 15L further has a recovery filter 152 and a recovery pump 153. Also, the recovery piping 151 includes a first recovery piping 151a and a second recovery piping 151b. It is noted that the virgin material piping 2b is used for the first recovery piping 151a and the second recovery piping 151b.

An upstream end of the first recovery piping 151a is connected to the bottom portion of the second cup portion 722 described with reference to FIG. 3. A downstream end of the first recovery piping 151a is connected to the recovery tank 154. Therefore, the first recovery piping 151a makes the chemical liquid expelled from the substrate W flow to the recovery tank 154.

The recovery filter 152 is interposed in the first recovery piping 151a. The recovery filter 152 removes foreign matter from the chemical liquid flowing in the first recovery piping 151a. The recovery filter 152 is housed, for example, in the fluid cabinet 410.

The second recovery piping 151b is housed in the fluid cabinet 410. One end of the second recovery piping 151b is connected to the recovery tank 154. The other end of the second recovery piping 151b is connected to the storage tank 411.

The recovery pump 153 is housed in the fluid cabinet 410. The recovery pump 153 is interposed in the second recovery piping 151b. The recovery pump 153 feeds the chemical liquid such that the chemical liquid flows in the second recovery piping 151b from the one end toward the other end of the second recovery piping 151b. As a result, the chemical liquid is recovered in the storage tank 411. The recovery pump 153 is controlled by the controller 400 (the controlling portion 401).

As illustrated in FIG. 4, one end of the first liquid supply piping 111 is connected to the first nozzle 5, and the other end of the first liquid supply piping 111 is connected to the circulation piping 191. When the first opening-closing valve 112 is opened, the chemical liquid flowing into the first liquid supply piping 111 from the circulation piping 191 flows in the first liquid supply piping 111 toward the first nozzle 5. As a result, the chemical liquid is discharged from the first nozzle 5. It is noted that the first nozzle 5 may be constituted of an end portion of the first liquid supply piping 111.

In the present preferred embodiment, the actuator of the first opening-closing valve 112 is a pneumatic actuator. The second gas line 18L supplies air to the actuator of the first opening-closing valve 112. The valve driving portion 500 changes the pressure of the air supplied to the actuator of the first opening-closing valve 112 via the second gas line 18L to open and close the first opening-closing valve 112. The valve driving portion 500 is controlled by the controller 400 (the controlling portion 401). The valve driving portion 500 is, for example, a speed controller.

The second gas line 18L has a second gas piping 181. The second gas piping 181 is a tubular member through which air (gas) flows. In the present preferred embodiment, the recycled material piping 2a is used for the second gas piping 181. A portion of the second gas piping 181 is disposed inside the fluid box 420.

As described with reference to FIG. 4, according to the present preferred embodiment, the virgin material piping 2b is used for the circulation piping 191. Therefore, as compared with a case where the recycled material piping 2a is used for the circulation piping 191, it becomes less likely that the number of particles on the substrate W increases.

Also, according to the present preferred embodiment, the recycled material piping 2a is used for the second gas piping 181. Therefore, the amount of the virgin material of fluororesin used in the substrate processing apparatus 100 can be reduced, as compared with a case where the virgin material piping 2b is used for the second gas piping 181. Thus, it is possible to save environmental resources.

Also, according to the present preferred embodiment, as described with reference to FIG. 2A and FIG. 2B, the marking (the first marking 30a) to identify the recycled material piping 2a and the virgin material piping 2b is performed on the recycled material piping 2a. Therefore, it is made possible to visually identify the recycled material piping 2a and the virgin material piping 2b. As a result, for example, at the time of the assembling or the maintenance of the substrate processing apparatus 100, it is possible to reduce a possibility that the recycled material piping 2a is mistakenly used for the circulation piping 191.

Also, according to the present preferred embodiment, as described with reference to FIG. 2A and FIG. 2B, as with the recycled material piping 2a, the marking (the first marking 30a) to identify the recycled material piping 2a and the virgin material piping 2b is performed also on the virgin material piping 2b. Therefore, it is possible to further reduce the possibility that the recycled material piping 2a is mistakenly used for the circulation piping 191.

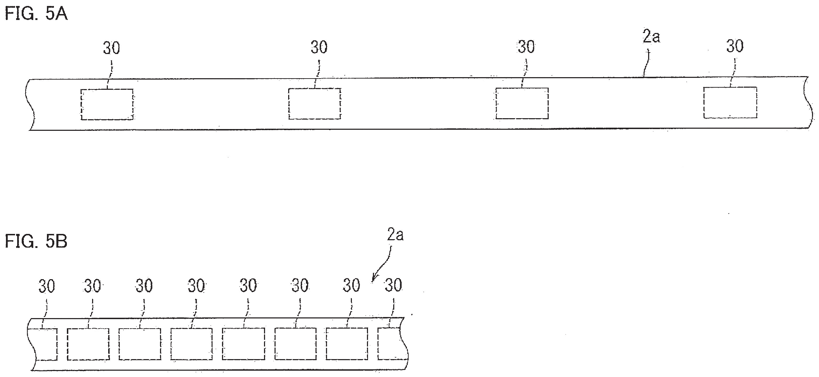

Next, with reference to FIG. 5A and FIG. 5B, the recycled material piping 2a and the virgin material piping 2b shall be described. FIG. 5A is a view illustrating an example of the recycled material piping 2a. FIG. 5B is a view illustrating another example of the recycled material piping 2a.

As illustrated in FIG. 5A, the marking portions 30 may be intermittently provided along a long direction of the recycled material piping 2a. In other words, the marking portions 30 may be intermittently provided on a tube molded product used for the recycled material piping 2a along a long direction of the tube molded product. Alternatively, as illustrated in FIG. 5B, the marking portions 30 may be successively provided along the long direction of the recycled material piping 2a. In other words, the marking portions 30 may be successively provided on the tube molded product used for the recycled material piping 2a along the long direction of the tube molded product. Similarly, the marking portions 30 may be intermittently provided along a long direction of the virgin material piping 2b or may be successively provided along the long direction of the virgin material piping 2b. In a case where the marking portions 30 are successively provided along the long direction of the recycled material piping 2a or the virgin material piping 2b, two marking portions 30 which are adjacent in the long direction may be in contact with each other or may be separated by a distance shorter than a length of one marking portion 30 in the long direction. The marking portion 30 includes one or more marks. The mark may be any of a letter, a number, a symbol, a figure, and an emoji or may be other than these. In a case where the marking portion 30 includes two or more marks, these marks may be in contact with each other or may be separated by a distance shorter than a length of one mark in the long direction of the recycled material piping 2a or the virgin material piping 2b.

Hereinafter, a tube molded product manufactured using a recycled material of fluororesin may be referred to as a "recycled material molded product." Also, a tube molded product manufactured using a virgin material of fluororesin may be referred to as a "virgin material molded product."

The tube molded products (recycled material molded product and virgin material molded product) have a fixed length. For example, the length of the tube molded product is 10 [m]. In a case where the tube molded product (recycled material molded product) is used for the recycled material piping 2a, the tube molded product is at times cut to a required length to produce the recycled material piping 2a from the tube molded product. Similarly, in a case where the tube molded product (virgin material molded product) is used for the virgin material piping 2b, the tube molded product is at times cut to a required length to produce the virgin material piping 2b from the tube molded product. Therefore, for example, in a case where marking is performed on just one location on the tube molded product, it may become impossible to distinguish, depending on a position where the tube molded product is cut, whether the piping produced from the tube molded product is the recycled material piping 2a or the virgin material piping 2b.

On the other hand, according to the recycled material piping 2a and the virgin material piping 2b described with reference to FIG. 5A and FIG. 5B, since the marking portion 30 is intermittently or successively provided along the long direction of the tube molded product, it is possible to identify whether the piping produced from the tube molded product is the recycled material piping 2a or the virgin material piping 2b, regardless of the position where the tube molded product is cut.

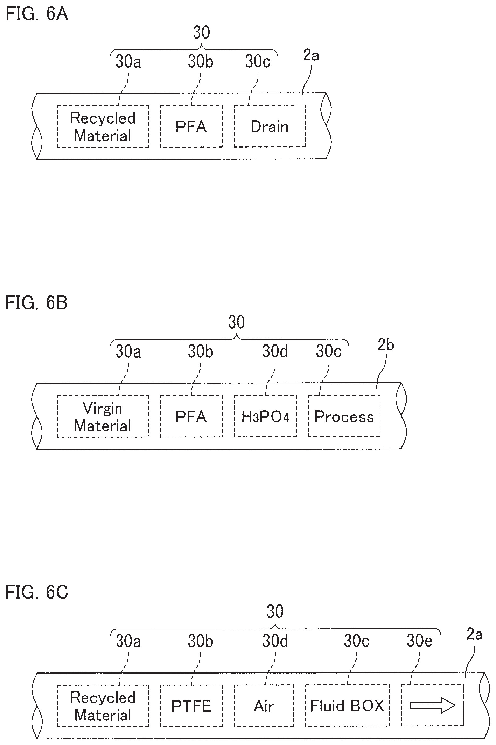

Next, with reference to FIG. 6A to FIG. 6C, modification examples of the marking portion 30 shall be described. FIG. 6A is a view illustrating a first modification example of the marking portion 30. FIG. 6B is a view illustrating a second modification example of the marking portion 30. FIG. 6C is a view illustrating a third modification example of the marking portion 30.

First, with reference to FIG. 6A, the first modification example of the marking portion 30 shall be described using the recycled material piping 2a as an example. As illustrated in FIG. 6A, the marking portion 30 may include a second marking 30b and a third marking 30c in addition to the first marking 30a described with reference to FIG. 2A and FIG. 2B. The second marking 30b indicates a type of fluororesin. The third marking 30c indicates a location where the recycled material piping 2a or the virgin material piping 2b is disposed.

FIG. 6A illustrates a case where the second marking 30b is letters indicating "PFA" and the third marking 30c is letters indicating "Drain." That is, the marking portion 30 indicates that a material of the recycled material piping 2a is "PFA" and a location where the recycled material piping 2a is installed is a "drain line." It is noted that the "drain line" is a line for expelling the processing liquid. For example, the drain line includes the drain line 16L illustrated in FIG. 3 and FIG. 4.

As illustrated in FIG. 6A, by indicating, with the marking portion 30, the location where the recycled material piping 2a is installed, it is made possible to reliably install the recycled material piping 2a at a target location, for example, at the time of assembling the substrate processing apparatus 100.

Next, with reference to FIG. 6B, the second modification example of the marking portion 30 shall be described using the virgin material piping 2b as an example. As illustrated in FIG. 6B, the marking portion 30 may include the second marking 30b to a fourth marking 30d in addition to the first marking 30a described with reference to FIG. 2A and FIG. 2B. The fourth marking 30d indicates a type of fluid flowing in the recycled material piping 2a or the virgin material piping 2b.

FIG. 6B illustrates a case where the second marking 30b is letters indicating "PFA," the third marking 30c is letters indicating "Process," and the fourth marking 30d is letters indicating phosphoric acid (H₃PO₄). That is, the marking portion 30 indicates that a material of the virgin material piping 2b is "PFA," a location where the virgin material piping 2b is installed is a "process line," and a fluid flowing in the virgin material piping 2b is phosphoric acid. It is noted that the "process line" is a line for supplying a processing liquid to the substrate processing portion 300. For example, the process line includes the first processing liquid line 11L and the second processing liquid line 12L illustrated in FIG. 3 and FIG. 4.

As illustrated in FIG. 6B, by indicating, with the marking portion 30, a type of fluid flowing in the virgin material piping 2b, it is made possible to reliably install the virgin material piping 2b at a target location, for example, at the time of assembling the substrate processing apparatus 100. Also, since an operator can check the type of fluid flowing in the virgin material piping 2b at the time of maintenance of the substrate processing apparatus 100, maintenance operation is facilitated.

Next, with reference to FIG. 6C, the third modification example of the marking portion 30 shall be described using the recycled material piping 2a as an example. As illustrated in FIG. 6C, the marking portion 30 may include the second marking 30b to a fifth marking 30e in addition to the first marking 30a described with reference to FIG. 2A and FIG. 2B. The fifth marking 30e indicates a direction of a fluid flowing in the recycled material piping 2a or the virgin material piping 2b.

FIG. 6C illustrates a case where the second marking 30b is letters indicating "PTFE," the third marking 30c is letters indicating "Fluid Box," the fourth marking 30d is letters indicating "Air," and the fifth marking 30e is a symbol indicating an arrow. That is, the marking portion 30 indicates that a material of the recycled material piping 2a is "PTFE," a location where the recycled material piping 2a is installed is the fluid box 420, a fluid flowing in the recycled material piping 2a is air, and the fluid (here, air) flows in a direction of the arrow.

As illustrated in FIG. 6C, by indicating, with the marking portion 30, the direction in which the fluid flows, since the operator can check the direction in which the fluid flows via the recycled material piping 2a for example, at the time of maintenance of the substrate processing apparatus 100, maintenance operation is facilitated.

The preferred embodiment of the present invention has been described above with reference to the drawings (FIG. 1 to FIG. 6C). According to the present preferred embodiment, the recycled material piping 2a can be used for the piping of the substrate processing apparatus 100. Therefore, it is possible to save environmental resources.

Also, according to the present preferred embodiment, marking is performed on the recycled material piping 2a and the virgin material piping 2b. Therefore, it is possible to visually identify the recycled material piping 2a and the virgin material piping 2b.

Also, according to the present preferred embodiment, an inner marking is performed on the recycled material piping 2a and the virgin material piping 2b. Therefore, it is possible to maintain the same cleanliness as in the arrangement that uses the piping on which marking is not performed.

It is noted that the present invention is not limited to the preferred embodiments described above and can be implemented in various modes within a scope not deviating from its gist. Also, it is possible to modify, as appropriate, the plurality of constituent elements disclosed in the preferred embodiments described above. For example, a certain constituent element among all constituent elements of a certain preferred embodiment may be added to the constituent elements of another preferred embodiment or some constituent elements among all constituent elements of a certain preferred embodiment may be deleted from the preferred embodiment.

The drawings mainly illustrate the respective constituent elements schematically to facilitate understanding of the invention and there are cases where thicknesses, lengths, numbers, intervals, etc., of the respective constituent elements illustrated differ from actuality due to convenience of drawing preparation. Also, the arrangements of the respective constituent elements indicated in the preferred embodiments described above are but an example, are not restricted in particular, and can obviously be changed variously within a scope of practically not deviating from the effects of the present invention.

For example, although in the preferred embodiments described with reference to FIG. 1 to FIG. 7B, each of the recycled material piping 2a and the virgin material piping 2b is the tubular member consisting of one layer of fluororesin, at least one of either of the recycled material piping 2a and the virgin material piping 2b may be a tubular member consisting of two or more layers of fluororesin.

For example, the recycled material piping 2a and the virgin material piping 2b may each include an outer layer and an inner layer not containing a substance that is photochemically changed by laser light and an intermediate layer containing a substance that is photochemically changed by the laser light. In this case, the marking portion 30 is formed in the intermediate layer. The substance that is photochemically changed by the laser light includes, for example a coloring pigment, a metal oxide, and a hydroxide.

Alternatively, at least one of either of the recycled material piping 2a and the virgin material piping 2b may be a tubular member consisting of two layers of fluororesin. For example, the recycled material piping 2a and the virgin material piping 2b may each have an outer layer and an inner layer not containing the substance that is photochemically changed by the laser light and a film sandwiched between the outer layer and the inner layer. In this case, the film contains the substance that is photochemically changed by the laser light. Therefore, the marking portion 30 is formed on the film.

Also, although in the preferred embodiments described with reference to FIG. 1 to FIG. 7B, marking is performed on both the recycled material piping 2a and the virgin material piping 2b, marking may be performed on just one of either of the recycled material piping 2a and the virgin material piping 2b.

Also, although in the preferred embodiments described with reference to FIG. 1 to FIG. 7B, marking is performed on each of the recycled material piping 2a and the virgin material piping 2b by forming the marking portions 30 on the recycled material piping 2a and the virgin material piping 2b, marking may be performed on one of either of the recycled material piping 2a and the virgin material piping 2b by coloring at least one of either of the recycled material piping 2a and the virgin material piping 2b.

For example, in a case where the recycled material piping 2a is colored, an entirety of the recycled material piping 2a may be colored or a portion of the recycled material piping 2a may be colored. Similarly, in a case where the virgin material piping 2b is colored, an entirety of the virgin material piping 2b may be colored or a portion of the virgin material piping 2b may be colored.

The mode of coloring is not restricted in particular as long as identification of the recycled material piping 2a and the virgin material piping 2b is possible. For example, in a case where a portion of the recycled material piping 2a is colored, colored portions may be intermittently provided in the long direction of the recycled material piping 2a over the entire circumference of the recycled material piping 2a. Alternatively, coloring may be performed on a portion in the circumferential direction of the recycled material piping 2a in a shape of a band that continuously extends in the long direction to both ends of the recycled material piping 2a. The same applies to a case where a portion of the virgin material piping 2b is colored.

In a case where both the recycled material piping 2a and the virgin material piping 2b are colored, that is, in a case where the recycled material piping 2a is colored with a recycled material indicator color and the virgin material piping 2b is colored with a virgin material indicator color, the recycled material indicator color and the virgin material indicator color may be made different from each other.

In a case where the recycled material piping 2a is colored, a colored portion of the recycled material piping 2a may be translucent or may be opaque. In the former case, a degree of transparency of the recycled material piping 2a may be a degree of transparency with which it is possible to visually identify whether or not a liquid is present in the recycled material piping 2a or may be a degree of transparency with which such visual identification is not possible. The same applies to the case where the virgin material piping 2b is colored.

In the case where the recycled material piping 2a is colored, a black coloring component different from fluororesin may be contained in the colored portion of the recycled material piping 2a. In this case, the recycled material piping 2a is colored black with a density corresponding to a concentration of the coloring component. In a case where the concentration of the coloring component is low, the recycled material piping 2a is colored gray (light black). The recycled material piping 2a may be colored black with a degree of transparency with which it is possible to visually identify whether or not a liquid is present in the recycled material piping 2a. The coloring component may be a substance such as blue other than black. The black coloring component may be carbon. In this case, the recycled material piping 2a can be colored without increasing contaminants such as a metal. The contents of this paragraph also apply to a case where the virgin material piping 2b is colored.

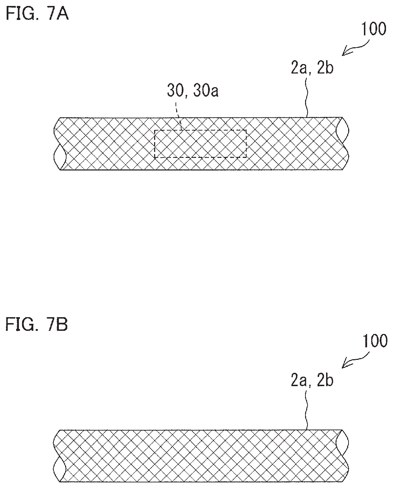

An entirety or a portion of the recycled material piping 2a may be colored, as well as forming the marking portion 30 on the recycled material piping 2a. Alternatively, an entirety or a portion of the recycled material piping 2a may be colored, without forming the marking portion 30 on the recycled material piping 2a. This also applies to the virgin material piping 2b. FIG. 7A illustrates an example in which an entirety of the recycled material piping 2a or the virgin material piping 2b is colored and the marking portion 30 is formed. FIG. 7B illustrates an example in which an entirety of the recycled material piping 2a or the virgin material piping 2b is colored and the marking portion 30 is not formed. In FIG. 7A and FIG. 7B, cross-hatched regions each represent a colored translucent regions.

Also, although in the preferred embodiments described with reference to FIG. 1 to FIG. 7B, a portion of the drain line 16L (the first drain piping 161) is disposed in the chamber 301, substantially an entire portion of the piping included in the drain line 16L may be disposed outside the chamber 301. For example, in a case where the first cup portion 712 is installed on a bottom wall of the chamber 301, substantially the entire portion of the piping included in the drain line 16L is disposed outside the chamber 301.

Also, although in the preferred embodiments described with reference to FIG. 1 to FIG. 7B, a portion of the recovery piping 151 is disposed inside the chamber 301, substantially an entire portion of the recovery piping 151 may be disposed outside the chamber 301. For example, in a case where the second cup portion 722 is installed on the bottom wall of the chamber 301, substantially the entire portion of the recovery piping 151 is disposed outside the chamber 301.

Also, although in the preferred embodiments described with reference to FIG. 1 to FIG. 7B, the spin chuck 3 is a clamping type chuck, the spin chuck 3 is not restricted to the clamping type chuck. For example, the spin chuck 3 may be a vacuum type chuck.

Also, although in the preferred embodiments described with reference to FIG. 1 to FIG. 7B, the substrate processing apparatus 100 is a single substrate processing type apparatus, the substrate processing apparatus 100 may be a batch type apparatus.

Also, although in the preferred embodiments described with reference to FIG. 1 to FIG. 7B, the substrate processing apparatus 100 is an etching apparatus or a cleaning apparatus, the substrate processing apparatus 100 is not restricted in particular as long as it is an apparatus that processes substrates. For example, the substrate processing apparatus 100 may be a coating apparatus, a developing apparatus, an exposure apparatus, a baking apparatus, or a film forming apparatus.

This application claims priority based on Japanese Patent Application No. 2023-158165 filed on September 22, 2023 and Japanese Patent Application No. 2024-110864 filed on July 10, 2024, and the entire contents of these applications are hereby incorporated herein by reference.

## Claims

1. A substrate processing apparatus that processes a substrate, the substrate processing apparatus comprising:
a plurality of pipings that have an inner surface and an outer surface wherein a fluid flows on an inner side of the inner surface, wherein
the plurality of pipings includes
at least one virgin material piping containing a virgin material of fluororesin, and
at least one recycled material piping containing a recycled material of fluororesin, and
at least one of either of marking and coloring to identify the virgin material piping and the recycled material piping is performed on at least one of either of the virgin material piping and the recycled material piping.

2. The substrate processing apparatus according to claim 1, wherein at least one of either of the virgin material piping and the recycled material piping has a marking portion between the inner surface and the outer surface on which marking to identify the virgin material piping and the recycled material piping is performed.

3. The substrate processing apparatus according to claim 1 or 2, further comprising a substrate processing portion that executes substrate processing on the substrate, wherein
the substrate processing portion has a chamber that houses the substrate,
the at least one virgin material piping includes a piping disposed inside the chamber, and
the at least one recycled material piping includes a piping disposed outside the chamber.

4. The substrate processing apparatus according to claim 3, wherein
the at least one virgin material piping includes a liquid supply piping that supplies a liquid to the substrate processing portion, and
a portion of the liquid supply piping is disposed inside the chamber, and the other portion of the liquid supply piping is disposed outside the chamber.

5. The substrate processing apparatus according to claim 3, further comprising a fluid cabinet that houses a liquid to be supplied to the substrate processing portion, wherein
the at least one virgin material piping includes a recovery piping that makes the liquid that is expelled from the substrate processing portion flow to the fluid cabinet, and
at least a portion of the recovery piping is disposed outside the chamber.

6. The substrate processing apparatus according to claim 3, wherein
the at least one recycled material piping includes a drain piping through which a liquid expelled from the substrate processing portion flows, and
the drain piping is disposed outside the chamber.

7. The substrate processing apparatus according to claim 3, wherein
the plurality of pipings include a liquid supply piping that supplies a liquid to the substrate processing portion,
the substrate processing apparatus further comprises:
an opening-closing valve that is provided on the liquid supply piping and controls flow of the liquid via the liquid supply piping and its stoppage; and
a fluid box that houses a portion of the liquid supply piping and the opening-closing valve,
the at least one recycled material piping includes a gas piping that makes a gas flow, and
a portion of the gas piping is disposed inside the fluid box.

8. The substrate processing apparatus according to claim 2, wherein the marking portion further indicates a type of the fluid flowing through the virgin material piping or the recycled material piping.

9. The substrate processing apparatus according to claim 2, wherein the marking portion further indicates a location where the virgin material piping or the recycled material piping is disposed.

10. The substrate processing apparatus according to claim 2, wherein the marking portion further indicates a direction in which the fluid flowing through the virgin material piping or the recycled material piping flows.

11. The substrate processing apparatus according to claim 1, wherein the coloring is performed on the virgin material piping.

12. The substrate processing apparatus according to claim 1 or 11, wherein the coloring of black color is performed on at least one of either of the virgin material piping and the recycled material piping.

13. The substrate processing apparatus according to claim 1 or 11, wherein at least one of either of the virgin material piping and the recycled material piping includes a translucent portion on which the coloring is performed.

14. The substrate processing apparatus according to claim 13, wherein the coloring of black color is performed to the translucent portion.
